Europäisches Patentamt

European Patent Office

Office européen des brevets

(11) Numéro de publication: **0 136 943**
**B1**

(12) # FASCICULE DE BREVET EUROPEEN

(45) Date de publication du fascicule du brevet:
**26.08.87**

(51) Int. Cl.⁴: **H 03 H 9/17,** H 03 H 9/05

(21) Numéro de dépôt: **84401916.6**

(22) Date de dépôt: **26.09.84**

(54) **Résonateur de faible sensibilité aux accélérations.**

(30) Priorité: **30.09.83 FR 8315653**

(43) Date de publication de la demande:
**10.04.85 Bulletin 85/15**

(45) Mention de la délivrance du brevet:
**26.08.87 Bulletin 87/35**

(84) Etats contractants désignés:
**BE CH DE GB IT LI NL SE**

(56) Documents cités:
**FR - A - 2 338 607**
**FR - A - 2 415 914**

(73) Titulaire: **COMPAGNIE D'ELECTRONIQUE ET DE PIEZO-ELECTRICITE - C.E.P.E., 44, rue de la Glacière, F-95100 Argenteuil (FR)**

(72) Inventeur: **Debaisieux, André, THOMSON-CSF SCPI 173, bld Haussmann, F-75379 Paris Cedex 08 (FR)**
Inventeur: **Aubry, Jean-Pierre, THOMSON-CSF SCPI 173, bld Haussmann, F-75379 Paris Cedex 08 (FR)**
Inventeur: **Michel, Luc, THOMSON-CSF SCPI 173, bld Haussmann, F-75379 Paris Cedex 08 (FR)**

(74) Mandataire: **Ruellan-Lemonnier, Brigitte et al, THOMSON-CSF SCPI 19, avenue de Messine, F-75008 Paris (FR)**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

## Description

La présente invention concerne un résonateur piézo-électrique à faible sensibilité aux accélérations, comportant une embase munie de poteaux de maintien d'une lame piézo-électrique, revêtue d'une électrode adhérente sur chacune de ses faces, chaque électrode étant reliée à un poteau conducteur, traversant l'embase, électriquement isolé de celle-ci.

Les résonateurs piézo-électriques sont utilisés généralement dans les oscillateurs constituant les bases de temps d'un grand nombre d'appareillages. La qualité essentielle d'une base de temps est de délivrer une fréquence aussi stable que possible en fonction des différents paramètres qui peuvent varier dans son environnement.

Dans le matériel aéronautique, tels que les avions, satellites etc., les bases de temps utilisées doivent être aussi peu sensibles que possible aux importantes accélérations auxquelles ces matériels sont soumis.

On a constaté que les résonateurs à quartz habituellement utilisés, généralement constitués d'une lame de quartz métallisée sur ses deux faces et fixée sur une embase à l'aide de poteaux de maintien et de poteaux conducteurs reliés aux électrodes, étaient sensibles aux accélérations, celles-ci provoquant des variations de phase du signal de la porteuse engendrant des variations de fréquences de celle-ci qui, dans de nombreuses applications, s'avèrent inacceptables. Les spécifications des constructeurs de matériels aéronautiques de plus en plus sophistiqués tendent à imposer des variations relatives de fréquence inférieure ou égale à $5 \times 10^{-10}$ pour une variation d'accélération de l'ordre de 1 g.

Le résonateur selon l'invention permet de résoudre le problème posé ci-dessus. Dans ce but, il est caractérisé en ce que la lame de matériau piézo-électrique est d'un seul tenant et présente une zone active centrale qui est le siège des ondes de volume du résonateur, entourée par une couronne périphérique reliée à ladite partie centrale par 2n ponts, avec n entier, supérieur ou égal à 2, lesdits ponts définissant entre la zone active et la couronne périphérique une pluralité de fentes de largeur L, ladite lame piézo-électrique étant fixée par sa couronne périphérique au poteau de maintien, les ponts étant disposés à l'intérieur d'un angle compris entre 8 et 25 degrés par rapport à l'axe ZZ' de la lame piézo-électrique.

De préférence les ponts seront disposés symétriquement par rapport à l'axe ZZ', la largeur L des fentes (correspondant également à la longueur des ponts) étant supérieure ou égale à environ 0,1 mm tandis que la largeur l des ponts sera supérieure ou égale à environ 0,2 mm. Les fentes séparant la partie active du résonateur de la couronne périphérique seront situées dans une zone dans laquelle l'amplitude des ondes de volume du résonateur sera pratiquement nulle. Cette zone est déterminée par simple mesure sur un résonateur sans fente des points de vibrations à sa surface, déterminant ainsi les limites de la zone active. Afin de restreindre celle-ci et éviter d'avoir des quartz de trop grandes dimensions, on donne, de manière connue en soi, une courbure à une au moins des faces de la lame piézo-électrique de manière à «focaliser» les ondes de volume entre les électrodes, celles-ci ne s'étendant pas généralement jusqu'à la limite de la zone active.

De préférence également, certains au moins des poteaux de maintien seront également des poteaux conducteurs. Ceci dépend essentiellement du nombre de poteaux de maintien. La lame piézo-électrique ne comportant que deux électrodes (une sur chaque face), deux au moins des poteaux de maintien seront généralement également des poteaux conducteurs, auxquels une électrode sera reliée. Les autres poteaux seront en général exclusivement des poteaux de maintien.

Dans tous les cas, les poteaux ayant une fonction de maintien de la lame piézo-électrique, c'est-à-dire les poteaux qui sont solidaires de la couronne périphérique de la lame, seront disposés sensiblement à mi-distance de deux ponts successifs. En effet, on a constaté que d'une manière générale les meilleurs résultats étaient obtenus lorsque l'on éloignait le plus possible les poteaux de maintien des ponts reliant la couronne périphérique et la zone active, ceci permettant d'obtenir un meilleur découplage mécanique des poteaux d'une part et de la zone active du quartz d'autre part.

L'invention sera mieux comprise à l'aide des exemples de réalisations suivants, donnés à titre non limitatif, conjointement avec les figures qui représentent:

La fig. 1, une vue de dessus d'une lame piézo-électrique conforme à l'invention;

la fig. 2, une vue en coupe selon l'axe P1, P'1 de la lame de la figure 1;

la fig. 3, une vue schématique d'une lame piézo-électrique montée sur une embase.

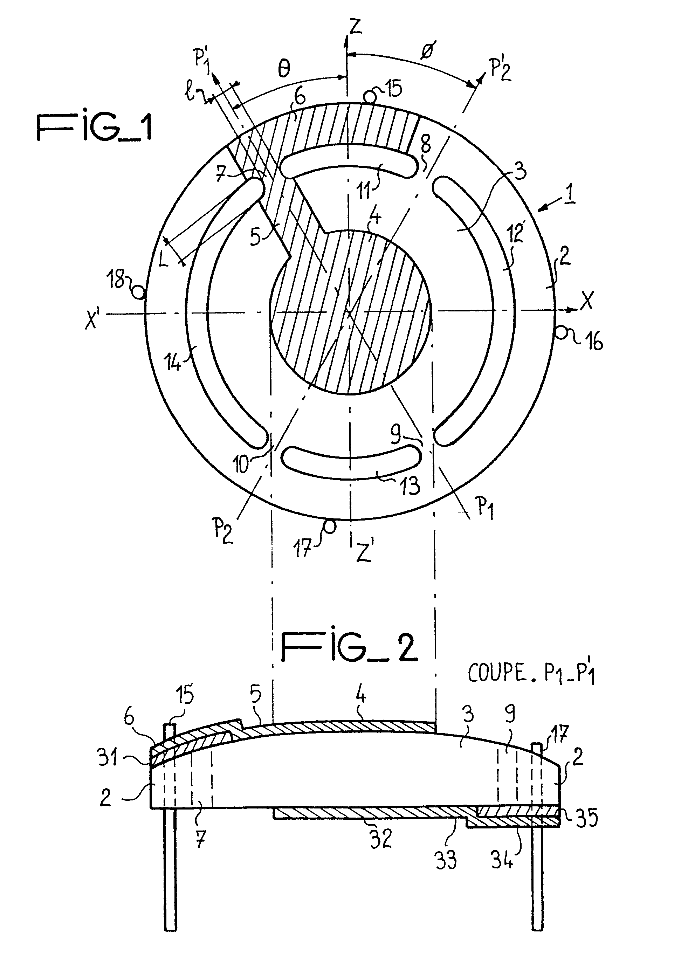

Sur la fig. 1, on a représenté schématiquement une lame piézo-électrique selon l'invention. Cette lame 1 en vue de dessus est de forme circulaire. Elle comporte une zone périphérique 2, une zone active 3 revêtue sur sa partie centrale d'une électrode 4, reliée par une zone de prolongement 5 à une zone conductrice métallisée 6, située sur la zone périphérique 2 et traversant le pont 7. Sur cette figure (qui n'est qu'un exemple de réalisation), le nombre de ponts reliant la zone périphérique 2 à la zone active 3 est égal à 4, respectivement les ponts 7, 8, 9 et 10. Les ponts 7 et 9 sont situés sur un axe qui fait un angle $\ominus$ avec l'axe ZZ' de la lame piézo-électrique, tandis que les ponts 8 et 10 sont situés sur un axe P2, P'2 qui fait un angle $\varnothing$ avec ledit axe ZZ' (l'axe ZZ' est l'axe conventionnel Z de repérage en fonction de la coupe cristallographique utilisée, axe bien connu de l'homme de métier. L'axe XX' qui définit avec l'axe ZZ' le plan de la vue de dessus de ladite lame est également l'axe X conventionnel de la coupe utilisée).

Les ponts 7, 8, 9 et 10 sont respectivement séparés les uns des autres par les fentes circulaires 11, 12, 13 et 14. Ces fentes traversent la lame de part en part et ont une largeur L (qui est également la longueur de chacun des ponts) qui ne sera généralement pas inférieure à environ 0,1 mm. On constate en effet en pratique que pour une largeur inférieure, les découplages mécaniques et par conséquent l'amélioration de la stabilité de fréquence qui en résulte, sont insuffisants. Chaque pont a également une largeur I qui n'est pas inférieure à 0,2 mm pour les mêmes raisons que celles invoquées ci-dessus. Les angles ⊖ et ∅ définis ci-dessus peuvent varier entre 8° et 25°. On constate en effet qu'à l'extérieur de cette zone, le module d'Young des lames piézo-électriques de quartz devient trop important et il en résulte un découplage mécanique entre la zone périphérique et la zone active insuffisant pour constater une amélioration de la stabilité en fréquence du résonateur. La lame piézo-électrique 1 est reliée dans cet exemple à quatre poteaux solidaires de l'embase. Deux de ces poteaux sont des poteaux conducteurs 15 et 17 tandis que les deux poteaux 16 et 18 sont des poteaux de maintien (le poteau 17 est un poteau conducteur relié à l'électrode inférieure 32 comme représentée sur la fig. 2). Les poteaux de maintien 16 et 18 ne sont pas absolument nécessaires pour l'obtention de bons résultats, ceux-ci étant déjà obtenus par la présence des deux poteaux conducteurs et de maintien 15 et 17. Les poteaux sont d'une manière générale disposés de manière à respecter la symétrie de l'ensemble. Dans l'exemple de la fig. 1, lesdits poteaux sont placés à mi-distance des deux ponts voisins, le poteau 15 étant par exemple sensiblement équidistant des ponts 7 et 8. Les angles ⊖ et ∅, qui ne sont pas égaux dans le cas de la figure, imposent donc une position des poteaux 15 et 17 non situés sur l'axe ZZ'. D'une manière générale, cependant, il est préférable que les angles ⊖ et ∅ soient sensiblement égaux de manière à disposer les poteaux 15 et 17 dans une zone située aux environs de l'axe ZZ', zone correspondant au module d'Young le plus faible de la lame de quartz, ladite zone correspondant également à une valeur minimum du coefficient de sensibilité accélérométrique Kf de la lame.

La fig. 2 représente une coupe P1, P'1 de la lame représentée sur la fig. 1, coupe sur laquelle les mêmes éléments portent les mêmes références. De manière à améliorer la conductivité électrique de la zone métallisée au niveau du pont 7 (ainsi qu'au niveau du pont 9 sur la face inférieure de la lame) on déposera généralement une sous couche métallique 31 plus épaisse que la métallisation 5 aux environs du pont 7 correspondant à la traversée de l'électrode de métallisation vers la zone métallisée 6. Cette sous patte métallisée 31 pourra également se prolonger si désiré sous toute la couche métallisée 6. Cette sous-patte est elle-même généralement déposée par métallisation sous vide. Elle peut être en un matériau adapté à ce type de dépôt, tel que le chrome, le cuivre, l'aluminium etc. Sur la fig. 2, on voit l'électrode inférieure 32 de la lame piézo-électrique se prolongeant par la zone de prolongement 33 traversant le pont 9 au-dessus de la sous-patte 35 revêtue par la zone métallisée 34. Cette zone métallisée 34 est reliée au poteau conducteur et de maintien 17 comme l'est la zone métallisée 6 au poteau conducteur et de maintien 15.

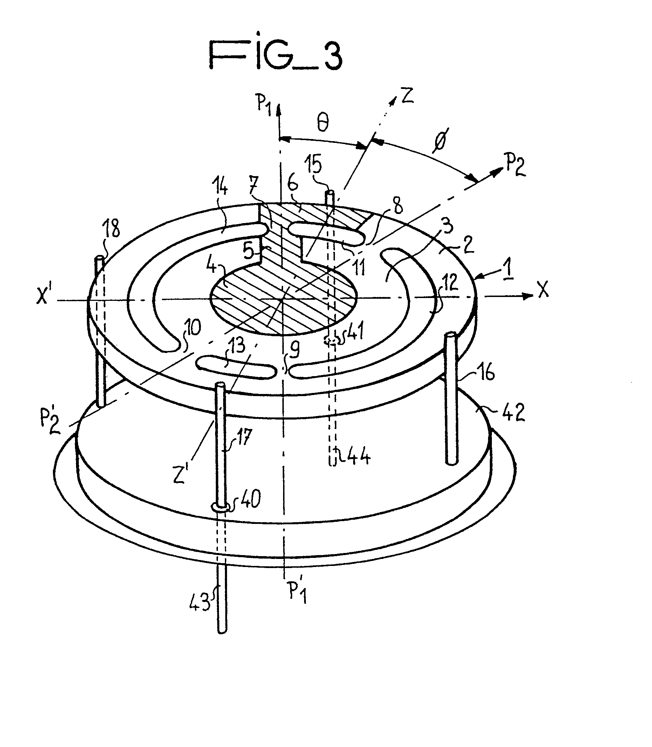

La fig. 3 représente une vue de la lame piézo-électrique des figures précédentes fixée sur son embase, figure sur laquelle les mêmes éléments que ceux des figures précédentes portent les mêmes références. Les poteaux conducteurs et de maintien 15 et 17 traversent respectivement l'embase 42 à travers une perle de verre isolante 41, 40 pour se prolonger par des poteaux extérieurs respectivement 44 et 43 qui pourront être soudés aux circuits utilisant ledit résonateur. Les poteaux de maintien 16 et 18 sont simplement solidaires de l'embase 42 et n'ont pas besoin d'être isolés électriquement de celles-ci.

D'une manière générale, on utilisera dans le cadre de la présente invention, de préférence une lame de quartz ayant une coupe voisine de la coupe SC. Les ponts auront généralement une longueur L de 1 mm, une largeur I de 0,5 mm, tandis que les angles ⊖ et ∅ seront égaux entre eux et de l'ordre de 15°. Comme on l'a précédemment, ces angles peuvent varier entre 8 et 25°, tandis que L peut varier entre 0,1 mm et 2 mm, I variant de 0,2 à 2,5 mm.

Il est bien entendu également que la couronne périphérique 2 peut-être elle-même incomplète c'est-à-dire ne pas entourer complètement la zone active.

Exemples comparatifs

Exemple 1

Résonateur plan convexe de 10 MHz de type SC P3

Rayon de courbure de la face convexe: 300 mm
Montage des poteaux sur ZZ' (2 points de maintien mécanique)
∅ de la lame: 15 mm
∅ métallisation: 6 mm
Sensibilité à la gravitation $\geq 3 \times 10^{-9}/2g$

Exemple 2

Résonateur plan convexe de 10 MHz de type SC P3

4 ponts disposés de manière quelconques
Largeur de la couronne périphérique: 1,5 mm
Largeur de la découpe: 1 mm
∅ de la lame: 15 mm
∅ de la partie active: 10 mm
∅ métallisation: 6 mm
Rayon de courbure: 300 mm
Sensibilité à la gravitation: $\geq 1 \ 10^{-9}/2g$, mais inférieure à $3 \times 10^{-9}/2 \ g$

Exemple 3

Résonateur plan convexe de 10 MHz de type SC P3

4 ponts disposés à ± 15° par rapport à l'axe ZZ'
∅ de la lame: 15 mm
∅ de la partie active: 10 mm
∅ métallisation: 6 mm
Sensibilité à la gravitation: $\leq 1 \ 10^{-9}/2g$

Dans les exemples 2 et 3, le nombre et la disposition des poteaux par rapport aux ponts (mi-distance) sont identiques, de même que la largeur de ceux-ci, de l'ordre de 0,5 mm. On constate par ailleurs que lorsque les quatre ponts sont situés dans un angle compris entre sensiblement 8° et 25° par rapport à l'axe ZZ', on obtient sensiblement les mêmes résultats que dans l'exemple 3 ci-dessus.

## Revendications

1. Résonateur piézo-électrique à faible sensibilité aux accélérations comportant une embase (42) munie de poteaux de maintien (15, 16, 17, 18) d'une lame piézo-électrique (1) revêtue d'une électrode adhérente (4, 32) sur chacune de ses faces, chaque électrode (4, 32) étant électriquement reliée à un poteau conducteur (15, 17), traversant l'embase (42), électriquement isolé (40, 41) de celle-ci, caractérisé en ce que la lame de matériau piézo-électrique (1) est d'un seul tenant et présente une zone active centrale (3) qui est le siège des ondes de volume du résonateur, entourée par une couronne périphérique (2) reliée à ladite partie centrale (3) par 2n ponts (7, 8, 9, 10), avec n entier, supérieur ou égal à 2, lesdits ponts (7, 8, 9, 10) définissant entre la zone active (3) et la couronne périphérique (2) une pluralité de fentes (11, 12, 13, 14) de largeur L, ladite lame piézo-électrique (1) étant fixée sur sa couronne périphérique (2) aux poteaux de maintien (15, 16, 17, 18), les ponts (7, 8, 9, 10) étant disposés à l'intérieur d'un angle compris entre 8° et 25° par rapport à l'axe ZZ' de la lame piézo-électrique (1).

2. Résonateur piézo-électrique à faible sensibilité aux accélérations selon la revendication 1, caractérisé en ce que les ponts (7, 8, 9, 10) sont disposés symétriquement par rapport à l'axe ZZ'.

3. Résonateur piézo-électrique à faible sensibilité aux accélérations selon l'une des revendications 1 ou 2, caractérisé en ce que la largeur L des fentes (11, 12, 13, 14) est ≥ 0,1 mm et inférieure ou égale à 2 mm.

4. Résonateur piézo-électrique à faible sensibilité aux accélérations selon l'une des revendications 1 à 3, caractérisé en ce que la largeur l des ponts (7, 8, 9, 10) est supérieure ou égale à 0,2 mm et inférieure ou égale à 2,5 mm.

5. Résonateur piézo-électrique à faible sensibilité aux accélérations selon l'une des revendications 1 à 4, caractérisé en ce que certains au moins des poteaux de maintien (15, 16, 17, 18) sont également des poteaux conducteurs (15, 17).

6. Résonateur piézo-électrique à faible sensibilité aux accélérations selon l'une des revendications 1 à 5, caractérisé en ce que la lame piézo-électrique est un quartz de coupe SC ou de coupe voisine de celle-ci.

7. Résonateur piézo-électrique à faible sensibilité aux accélérations selon l'une des revendications 1 à 6, caractérisé en ce que les poteaux de maintien (15, 16, 17, 18) sont situés sensiblement à mi-distance de deux ponts successifs (7, 8, 9, 10).

## Patentansprüche

1. Piezoelektrischer Resonator geringer Empfindlichkeit gegenüber Beschleunigungen, mit einer Basis (42), auf der Säulen (15, 16, 17, 18) zum Halten eines piezoelektrischen Plättchens (1) aufgebracht sind, wobei auf jeder Seite des Plättchens (1) eine Elektrode (4, 32) anhaftet, die elektrisch an eine die Basis (42) in elektrisch isolierender Weise (41, 42) durchdringende leitende Säule (15, 17) angeschlossen ist, dadurch gekennzeichnet, dass das Plättchen (1) aus piezoelektrischem Material aus einem Stück besteht und eine zentrale aktive Zone (3) besitzt, in der die Raumwellen des Resonators entstehen und die von einem peripheren Ring (2) umgeben ist, welcher an die zentrale Zone (3) über 2n Brücken (7, 8, 9, 10) angeschlossen ist, wobei n eine ganze Zahl ≥ 2 ist und die Brücken (7, 8, 9, 10) zwischen der aktiven Zone (3) und dem peripheren Ring (2) eine Vielzahl von Schlitzen (11, 12, 13, 14) einer Breite L definieren, dass das piezoelektrische Plättchen (1) über seinen peripheren Ring (2) an den Haltesäulen (15, 16, 17, 18) befestigt ist und dass die Brücken (7, 8, 9, 10) innerhalb eines Winkels angeordnet sind, der mit der Achse ZZ' des piezoelektrischen Plättchens (1) einen Winkel zwischen 8 und 25° einschliesst.

2. Piezoelektrischer Resonator geringer Empfindlichkeit gegenüber Beschleunigungen nach Anspruch 1, dadurch gekennzeichnet, dass die Brücken (7, 8, 9, 10) symmetrisch bezüglich der Achse ZZ' angeordnet sind.

3. Piezoelektrischer Resonator geringer Empfindlichkeit gegenüber Beschleunigungen nach einem der Ansprüche 1 oder 2, dadurch gekennzeichnet, dass die Breite L der Schlitze (11, 12, 13, 14) ≥ 0,1 mm und ≤ 2 mm ist.

4. Piezoelektrischer Resonator geringer Empfindlichkeit gegenüber Beschleunigungen nach einem der Ansprüche 1 bis 3, dadurch gekennzeichnet, dass die Breite I der Brücken (7, 8, 9, 10) ≥ 0,2 mm und ≤ 2,5 mm ist.

5. Piezoelektrischer Resonator geringer Empfindlichkeit gegenüber Beschleunigungen nach einem der Ansprüche 1 bis 4, dadurch gekennzeichnet, dass mindestens einzelne der Haltesäulen (15, 16, 17, 18) zugleich leitende Säulen (15, 17) sind.

6. Piezoelektrischer Resonator geringer Empfindlichkeit gegenüber Beschleunigungen nach einem der Ansprüche 1 bis 5, dadurch gekennzeichnet, dass das piezoelektrische Plättchen ein Quarz eines Kristallschnitts SC oder eines ähnlichen Schnitts ist.

7. Piezoelektrischer Resonator geringer Empfindlichkeit gegenüber Beschleunigungen nach einem der Ansprüche 1 bis 6, dadurch gekennzeichnet, dass die Haltesäulen (15, 16, 17, 18) im wesentlichen in der Mitte zwischen zwei aufeinanderfolgenden Brücken (7, 8, 9, 10) liegen.

## Claims

1. A piezoelectric resonator with low sensibility for accelerations, comprising a base (42) provided with columns (15, 16, 17, 18) for holding a piezoelectric wafer (1), an electrode (4, 32) being attached to each side of the wafer, each electrode (4, 32) being electrically connected to a conductive column (15, 17) which passes through the base (42) in an electrically insulating manner (40, 41), characterized in that the wafer of piezoelectric material (1) is made of one block and presents an active central zone (3) in which the volume waves of the resonator are created and which is surrounded by a peripheral ring (2) connected to said central zone (3) via 2n bridges (7, 8, 9, 10), n being an integer $\geq$ 2, said bridges (7, 8, 9, 10) defining between the active zone (3) and the peripheral ring (2) a plurality of slots (11, 12, 13, 14) of the width L, said piezoelectric wafer (1) being fixed through its peripheral ring (2) to the holding columns (15, 16, 17, 18), the bridges (7, 8, 9, 10) being disposed inside an angle of between 8 and 25° with respect to the axis ZZ' of the piezoelectric wafer (1).

2. A piezoelectric resonator with low sensibility for accelerations according to claim 1, characterized in that the bridges (7, 8, 9, 10) are disposed symmetrically with respect to the axis ZZ'.

3. A piezoelectric resonator with low sensibility for accelerations according to one of claims 1 or 2, characterized in that the width L of the slots (11, 12, 13, 14) is $\geq$ 0,1 mm and $\leq$ 2 mm.

4. A piezoelectric resonator with low sensibility for accelerations according to one of claims 1 to 3, characterized in that the width I of the bridges (7, 8, 9, 10) is $\geq$ 0,2 mm and $\leq$ 2,5 mm.

5. A piezoelectric resonator with low sensibility for accelerations according to one of claims 1 to 4, characterized in that at least certain ones of the holding columns (15, 16, 17, 18) are also conductive columns (15, 17).

6. A piezoelectric resonator with low sensibility for accelerations according to one of claims 1 to 5, characterized in that the piezoelectric wafer is a quartz with a cut line SC or a similar cut line.

7. A piezoelectric resonator with low sensibility for accelerations according to one of claims 1 to 6, characterized in that the holding columns (15, 16, 17, 18) are arranged substantially half-way between two successive bridges (7, 8, 9, 10).

0136943

FIG_1

FIG_2

COUPE. $P_1$-$P'_1$

7

# FIG_3